# EUROPÄISCHE PATENTSCHRIFT

(11) **EP 1 709 261 B1**
(45) Veröffentlichungstag und Bekanntmachung des Hinweises auf die Patenterteilung: **16.01.2008**
(21) Anmeldenummer: 04804450.7
(22) Anmeldetag: 30.12.2004
(51) Int. Cl.: E04F 13/08

(54) **FASSADENVERKLEIDUNG**
FAÇADE COVERING
REVETEMENT DE FAÇADE

(30) Priorität: 26.01.2004 DE 102004003880
(43) Veröffentlichungstag der Anmeldung: 11.10.2006
(73) Patentinhaber: Ingo Maurer GmbH, 80801 München (DE)
(72) Erfinder: MAURER, Ingo, 80801 München (DE)
(74) Vertreter: Schoppe, Fritz
(86) Internationale Anmeldenummer: PCT/EP2004/014865
(87) Internationale Veröffentlichungsnummer: WO 2005/071183

(56) Entgegenhaltungen:
- EP-A- 1 256 687
- WO-A-20/04048736
- DE-A1- 4 200 879
- DE-A1- 10 045 629
- "LEUCHTENDE BILDER IN GLASSCHEIBEN" 25. Oktober 2002 (2002-10-25), XP002241074 Gefunden im Internet: URL:www.schott.com/architecture/english/ne ws/press.html> [gefunden am 2003-05-13]

## Beschreibung

Die vorliegende Erfindung betrifft eine Fassadenverkleidung. Insbesondere befaßt sich die vorliegende Erfindung mit einer Fassadenverkleidung zum Verkleiden einer Außenwand eines Bauwerks mit einer Mehrzahl von an der Außenwand des Bauwerks befestigbaren Fassadenverkleidungsplatten.

Es ist üblich, die Außenwände eines Bauwerkes, wie beispielsweise eines Hauses, mit einer Fassadenverkleidung zu versehen.

Im Bereich der Einfamilienhäuser wird häufig die der Wetterseite zugewandte Außenwand mit einer Verkleidung versehen, die im einfachsten Fall aus einer Vielzahl von Trägerlatten besteht, auf denen vorgefertigte Betonfaserstoffplatten oder Asbestplatten aufgebracht werden, welche anschließend mit einer Fassadenfarbe gestrichen werden. Das optische Erscheinungsbild einer derartigen Plattenfassade kann nicht befriedigen.

Moderne Hochhausfassaden werden üblicherweise mit Fassadenverkleidungen versehen, die aus Metallträgerkonstruktionen bestehen, in die die Gebäudefenster eingesetzt sind. Wandbereiche zwischen den Fenstern sowie diejenigen Fassadenbereiche, die die jeweiligen Eckenkonstruktionen abdecken, bestehen gängigerweise aus eloxierten Aluminiumplatten oder beschichteten Metallplatten. Derartige Fassadenverkleidungen wirken häufig wenig ansprechend, gelegentlich sogar etwas trist. Auch vom Raumklima her erweisen sich Fassaden, die durch geschlossene Aluminiumplattenkonstruktionen gebildet sind, als problematisch, da derartige Wandkonstruktionen keinen Luftdurchtritt ermöglichen, so daß Gebäude mit derartigen Wandkonstruktionen auf eine wirksame Innenbelüftung angewiesen sind, um Feuchtigkeitsablagerungen und Kondensationen im Bereich der Fassadenwände zu verhindern.

Letztlich sind derartige Fassadenkonstruktionen auch vergleichsweise kostspielig.

Die in ländlichen Bereichen übliche Art der Fassadenverkleidung besteht häufig aus Holzelementen oder Holzpaneelen, die mittels eines Holzladenträgers an Außenwänden eines Hauses angebracht sind. Diese Art einer Fassadenverkleidung mag zwar nicht allen architektonischen Anforderungen entsprechen, ermöglicht jedoch ein sogenanntes Atmen der Wände des Bauwerks, also einen Durchtritt von Feuchtigkeit aus dem Innenbereich des mit einer derartigen Fassadenverkleidung versehenen Hauses durch die Ziegelwand und durch die Holzpaneelen in die Umgebungsatmosphäre. Ferner ist eine derartige Holzfassadenverkleidung vergleichsweise preisgünstig.

Aus der DE 10045629 A1 ist bereits eine Fassadenverkleidung zum Verkleiden einer Außenwand eines Bauwerks mit einer Mehrzahl von an de Außenwand des Bauwerks befestigbaren Fassadenverkleidungsplatten bekannt. Die bekannten Fassadenverkleidungsplatten haben einen Grundprofilkörper aus weichem PVC, in dessen Oberfläche Leiterbahnen eingelegt sind, an die hohe Spannungspulse zum Zwecke der Abwehr von Vögeln anlegbar sind.

Aus der EP-A-1 256 687 sowie aus der Fachveröffentlichung "Leuchtende Bilder in Glasscheiben", 25. Oktober 2002 (2002-10-25). XP002241074 im Internet: URL:www.schott.com/architecture/english/news/press.html>[ge funden am 2003-05-13] ist es bekannt, dass transparente Glasleiterplatten mit Leuchtdioden zur Beleuchtung von Gebäudefassaden verwendet werden.

Ausgehend von diesem Stand der Technik liegt der vorliegenden Erfindung die Aufgabe zugrunde, eine wetterfeste Fassadenverkleidung zu schaffen, die eine optisch ansprechende Oberflächengestaltung aufweist.

Diese Aufgabe wird durch eine Fassadenverkleidung gemäß Patentanspruch 1 gelöst.

Der Erfindung liegt die Erkenntnis zugrunde, daß sich die für die Fertigung elektronischer Geräte üblichen Leiterplatten in herausragender Weise für die Verkleidung von Fassaden von Bauwerken eignen, ohne daß es irgendwelcher zusätzlicher Behandlungen dieser Leiterplatten beispielsweise mittels Farbe oder Lacken bedürfte. Handelsübliche Leiterplatten zeigen eine ästhetisch ansprechende Oberflächenstruktur, die durch Leiterbahnen, metallisierte Durchgangslöcher zur Aufnahme von Anschlußdrähten oder Befestigungselementen elektronischer Bauelemente und durch farbige, häufig grünlich-durchsichtige Isolierlackschichten bestimmt ist.

Der Erfindung liegt die weitere Erkenntnis zugrunde, daß handelsübliche Leiterplatten nicht nur die beschriebenen, optisch ansprechenden Eigenschaften haben, sondern resistent gegen Witterungs- und Umweltflüsse sind, ohne daß es hier zu weiteren Schutzmaßnahmen, wie beispielsweise einer zusätzlichen Schutzlackschicht bedürfte.

Die in Leiterplatten typischerweise vorgesehenen Durchbohrungen oder Durchgangslöcher für die Aufnahme von Anschlußelementen elektronischer Bauelemente stellen eine erwünschte Porosität der Oberfläche dar, aufgrund der das erwünschte "Atmen" des mit derartigen Leiterplatten versehenen Bereichs einer Außenwand gewährleistet ist.

Weitere Gestaltungsmöglichkeiten der mit der erfindungsgemäßen Fassadenverkleidung versehenen Bauwerke ergeben sich daraus, daß die als Fassadenverkleidungsplatte verwendeten Leiterplatten mit Leuchtdioden bestückbar sind, um auf diese Weise die Gebäudefassade selbst bei Nacht erleuchten zu lassen.

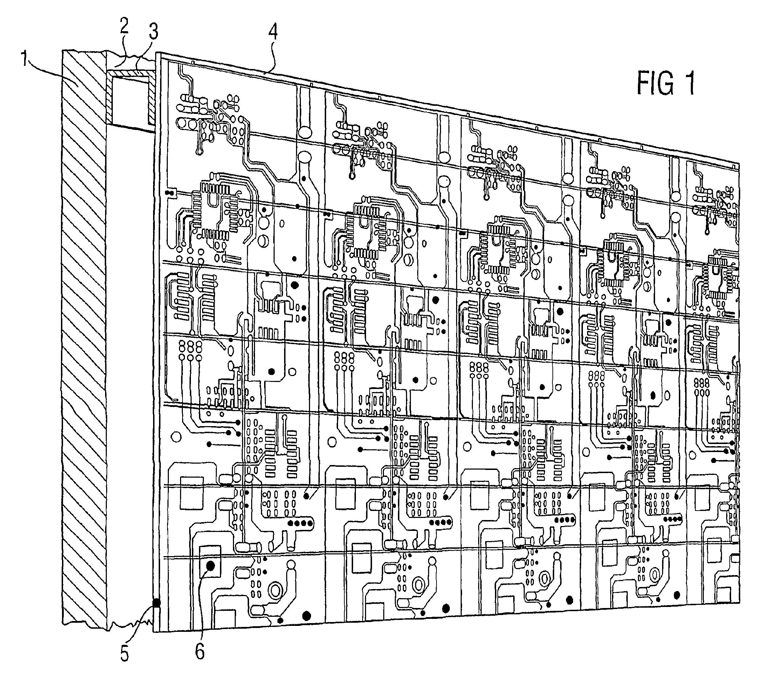

Ein bevorzugtes Ausführungsbeispiel der vorliegenden Erfindung wird nachfolgend unter Bezugnahme auf die beiliegende Zeichnung näher erläutert. Es zeigt:
Die einzige Figur eine Teilschnittdarstellung einer mit der erfindungsgemäßen Fassadenverkleidung versehenen Gebäudewand.

Eine Außenwand 1 eines Bauwerks, die in der Figur in Teilschnittdarstellung gezeigt ist, und die beispielsweise als unverputzte Ziegelwand ausgeführt sein kann, ist an ihrer Außenseite 2 mit im Querschnitt U-förmigen Trägerprofilen 3 versehen, die beispielsweise aus Leichtmetall bestehen.

Obwohl in der zeichnerischen Darstellung der Figur nur ein einziges Trägerprofil 3 gezeigt ist, ist es für den Fachmann offenkundig, daß die Trägerprofile 3 in derartigen gegenseitigen Abständen auf der Außenseite 2 der Außenwand 1 angeordnet sind, daß zumindest immer zwei Trägerprofile 3 mit je einer Leiterplatte Eingriff nehmen, die jeweils in ihrer Gesamtheit mit dem Bezugszeichen 4 bezeichnet ist.

Jede der Leiterplatten 4 besteht, wie dies im Bereich der Leiterplattentechnik üblich ist, aus einem Epoxidträger 5, an dessen nach außen gerichteter Hauptoberfläche eine Mehrzahl von metallischen Strukturen 6 vorgesehen sind, die sich typischerweise zwischen einzelnen Durchgangslöchern erstrecken, die zur Aufnahme von Anschlußelementen elektronischer Bauelemente ausgebildet sind.

Die Leiterplatten können an einer Vielzahl von Stellen mit Leuchtdioden (nicht dargestellt) bzw. anderen geeigneten Leuchtmitteln bestückt sein, um auf diese Weise eine Fassadenbeleuchtung zu implementieren.

Die sich aus den Leiterbahnstrukturen, den Durchgangslöchern und den Metallisierungsbereichen der Leiterplattenoberfläche ergebenden Muster der Fassadenoberfläche, verleihen dem mit der erfindungsgemäßen Fassadenverkleidung versehenen Gebäude eine ungewöhnliche, auffällige Erscheinung.

Aufgrund der Beständigkeit von Leiterplatten gegenüber Feuchtigkeit und Umwelteinflüssen bleibt das positive Erscheinungsbild der mit der erfindungsgemäßen Fassadenverkleidung versehenen Gebäude, über Jahre erhalten.

## Patentansprüche

1. Fassadenverkleidung zum Verkleiden einer Außenwand (1) eines Bauwerks mit einer Mehrzahl von an der Außenwand (1) des Bauwerks befestigbaren Fassadenverkleidungsplatten,
**dadurch gekennzeichnet,**
**daß** die Fassadenverkleidungsplatten Leiterplatten (4) sind, die jeweils einen Epoxidträger umfassen.

2. Fassadenverkleidung nach Anspruch 1, **dadurch gekennzeichnet,**
**daß** die Leiterplatten (4) an ihrer nach außen gerichteten Hauptfläche (2) metallische Leiterbahnstrukturen (6) aufweisen.

3. Fassadenverkleidung nach Anspruch 1 oder 2, **dadurch gekennzeichnet,**
**daß** die Leiterplatten eine Mehrzahl von Durchgangslöchern aufweisen, wobei die Durchgangslöcher zur Aufnahme von Anschlußelementen elektronischer Bauelemente geeignet sind.

4. Fassadenverkleidung nach einem der Ansprüche 1 bis 3, **dadurch gekennzeichnet,**
**daß** wenigstens eine der Leiterplatten (4) mit Leuchtdioden bestückt ist.

## Claims

1. A façade covering for covering an outer wall (1) of a building with a plurality of façade covering boards mountable at the outer wall (1) of the building,
**characterized in that**
the façade covering boards are circuit boards (4), each comprising an epoxide carrier.

2. The façade covering according to claim 1, **characterized in that**
the circuit boards (4) have metallic conductive trace structures (6) at their main surface (2) directed to the outside.

3. The façade covering according to claim 1 or 2, **characterized in that**
the circuit boards have a plurality of vias, wherein the vias are suitable for receiving connecting elements of electronic devices.

4. The façade covering according to any one of claims 1 to 3, **characterized in that**
at least one of the circuit boards (4) is loaded with light-emitting diodes.

## Revendications

1. Revêtement de façade destiné à revêtir un mur extérieur (1) d'un bâtiment, avec une pluralité de plaques de revêtement de façade pouvant être fixées au mur extérieur (1) du bâtiment,
**caractérisé par le fait**
**que** les plaques de revêtement de façade sont des plaques conductrices (4) comprenant, chacune, un support époxyde.

2. Revêtement de façade selon la revendication 1, **caractérisé par le fait**
**que** les plaques conductrices (4) présentent, sur leur face principale orientée vers l'extérieur (2), des structures de chemin de conducteurs métalliques (6).

3. Revêtement de façade selon la revendication 1 ou 2, **caractérisé par le fait**
**que** les plaques conductrices présentent une pluralité de trous de passage, les trous de passage convenant pour recevoir des éléments de raccordement de composants électroniques.

4. Revêtement de façade selon l'une des revendications 1 à 3, **caractérisé par le fait**
**qu**'au moins l'une des plaques conductrices (4) est équipée de diodes électroluminescentes.
